# EUROPEAN PATENT APPLICATION

(11) **EP 3 905 521 A1**
(43) Date of publication of application: **03.11.2021**
(21) Application number: 19905263.0
(22) Date of filing: 27.11.2019
(51) Int. Cl.: H03H 9/17

(54) **RESONATOR WITH EXTENSION STRUCTURE AT CONNECTION PORTION OF TOP ELECTRODE, FILTER AND ELECTRONIC DEVICE**

(30) Priority: 26.12.2018 CN 201811601684
(71) Applicant: Tianjin University, Tianjin 300072 (CN); Rofs Microsystem (Tianjin) Co., Ltd, Tianjin 300462 (CN)
(72) Inventor: YANG, Qingrui, Tianjin 300072 (CN); PANG, Wei, Tianjin 300072 (CN); ZHANG, Menglun, Tianjin 300072 (CN)
(74) Representative: Bandpay & Greuter
(86) International application number: PCT/CN2019/121097
(87) International publication number: WO 2020/134804

(57) **Abstract**

The present disclosure relates to a bulk acoustic resonator, including: a substrate; an acoustic mirror; a bottom electrode arranged above the substrate; a top electrode; and a piezoelectric layer arranged above the bottom electrode and between the bottom electrode and the top electrode, wherein: the overlapping region of the acoustic mirror, the bottom electrode, the piezoelectric layer and the top electrode in the thickness direction of the resonator constitutes an effective region of the resonator; and the resonator is provided with an extension structure at the position of an electrode connection part of the top electrode, and the extension structure includes a main extension part located between the edge of the effective region and the edge of the bottom electrode on the projection along the thickness direction of the resonator. The present disclosure further relates to a filter having the above-mentioned resonator, and electronic equipment having the filter or the resonator.

## Description

### Technical Field

Embodiments of the present disclosure relate to the field of semiconductors, in particular to a bulk acoustic resonator, a filter having the resonator, and electronic equipment having the filter or the resonator.

### Background Art

Since a bulk acoustic resonator has the advantages of high operating frequency, high quality factor, small volume and low cost, a corresponding bulk acoustic filter has the advantages of low insertion loss, high rectangular coefficient, high power capacity, and so on. Therefore, this type of miniaturized high-performance bulk acoustic filters is widely used in radio frequency front ends of wireless communication systems, and is an important gateway for radio frequency signals to enter and exit the communication systems.

The bulk acoustic resonators are generally divided into two types, namely film bulk acoustic resonators and solid-state assembly resonators. These two structures have the same resonant layer structure, but have different acoustic reflection structures, wherein the resonant layer structure comprises upper and lower metal electrodes sandwiching a layer of piezoelectric material, which is a key structure that determines the resonant characteristics of the resonator. Under ideal conditions, the resonant layer works in a main vibration mode that expands along the thickness direction. However, due to the lateral boundary of the bulk acoustic resonator, a laterally propagating parasitic mode will be generated in the resonator, which is called lamb wave. This kind of lateral mode acoustic waves will leak into a substrate from the both sides of the resonator, which is shown as a decrease in the parallel impedance (Rₚ) or a quality factor (Qₚ) of the parallel resonance frequency on the electrical performance of the resonator.

In order to overcome the decrease in the Rₚ value caused by the lateral mode leakage, an annular protrusion structure can be added on the edge of an effective region of an upper electrode or a lower electrode, this annular protrusion structure can cause impedance mismatch at the edge of the effective region, such that acoustic waves are reflected into an effective excitation region at the boundary, thus may be converted into the main vibration mode, and accordingly, the parallel impedance Rₚ is improved.

However, this kind of annular protrusion structure is generally more effective at the edge of a non-upper electrode connection side of the resonator, and at the edge of an upper electrode connection side, the impedance mismatch introduced by the protrusion structure is not the same.

### Summary of the Invention

In order to obtain a resonator with better parallel impedance Rₚ performance, it is necessary to further optimize the impedance mismatch at an upper electrode connection edge of the resonator, so as to finally achieve better filter performance.

In order to further improve the parallel impedance value of the resonator, the present disclosure is proposed.

According to one aspect of the embodiments of the present disclosure, a bulk acoustic resonator is proposed, including: a substrate; an acoustic mirror; a bottom electrode arranged above the substrate; a top electrode; and a piezoelectric layer arranged above the bottom electrode and between the bottom electrode and the top electrode, wherein: the overlapping region of the acoustic mirror, the bottom electrode, the piezoelectric layer and the top electrode in the thickness direction of the resonator constitutes an effective region of the resonator; and the resonator is provided with an extension structure at the position of an electrode connection part of the top electrode, and the extension structure includes a main extension part located between the edge of the effective region and the edge of the bottom electrode on the projection along the thickness direction of the resonator.

Optionally, the main extension part extends from the edge of the effective region.

Optionally, the end of the main extension part away from the effective region is flush with the end part of the bottom electrode in the thickness direction of the resonator.

Further, the extension distance of the main extension part is not less than 1 micron.

Optionally, the extension structure further includes an auxiliary extension part arranged on the same layer as the main extension part, and the auxiliary extension part is connected to the other end of the main extension part and extends beyond the bottom electrode on the projection in the thickness direction of the resonator.

Optionally, the extension length of the auxiliary extension part is not less than 2 microns.

Optionally, the resonator further includes a passivation layer arranged above the top electrode; and the extension structure is arranged on the passivation layer.

Further optionally, the resonator further includes a passivation layer arranged above the top electrode; and the extension structure is arranged between the passivation layer and the top electrode.

Optionally, the extension structure is arranged between the top electrode and the piezoelectric layer.

Optionally, one end of the main extension part extends from the edge of the effective region; and the resonator further includes a protrusion structure extending from the edge of the effective region toward the effective region.

Optionally, the protrusion structure is in the same layer as the main extension part, and is connected to the one end of the main extension part.

Optionally, the protrusion structure and the main extension part are arranged in different layers.

Optionally, the acoustic impedance of the material of the protrusion structure is not greater than the acoustic impedance of the material of the extension structure.

Optionally, the thickness of the main extension part is not less than the thickness of the protrusion structure.

Optionally, the resonator further includes an annular protrusion, the annular protrusion is arranged in a ring shape at the inner side of the effective region, and the protrusion structure is a component of the annular protrusion.

Optionally, the extension structure further includes a second auxiliary extension part, and the second auxiliary extension part is connected to one end of the main extension part and extends into the effective region.

The embodiments of the present disclosure further relate to a filter, including the above-mentioned bulk acoustic resonator.

The embodiments of the present disclosure further relate to electronic equipment, including the above-mentioned filter or resonator.

### Brief Description of the Drawings

The following description and the drawings can better help understand these and other features and advantages in various embodiments disclosed in the present disclosure. The same reference signs in the figures always denote the same components, wherein:
Fig. 1 is a top view of a bulk acoustic resonator according to an exemplary embodiment of the present disclosure;
Fig. 1A is a cross-sectional view taken along the direction 1B-1B in Fig. 1 according to an exemplary embodiment of the present disclosure;
Fig. 1B is a cross-sectional view taken along the direction 1B-1B in Fig. 1 according to an exemplary embodiment of the present disclosure;
Fig. 1C is a cross-sectional view taken along the direction 1B-1B in Fig. 1 according to an exemplary embodiment of the present disclosure;
Fig. 2 is a parallel impedance curve diagram of a bulk acoustic resonator without an extension structure;
Fig. 3 is a parallel impedance curve of a bulk acoustic resonator provided with an extension structure according to an exemplary embodiment of the present disclosure;
Fig. 4 is a parallel impedance curve diagram of a bulk acoustic resonator only provided with an extension structure at the inner side of the effective region;
Fig. 5 is a top view of a bulk acoustic resonator according to an exemplary embodiment of the present disclosure;
Fig. 5A is a cross-sectional view taken along the direction 2B-2B in Fig. 5 according to an exemplary embodiment of the present disclosure;
Fig. 5B is a cross-sectional view taken along the direction 2B-2B in Fig. 5 according to an exemplary embodiment of the present disclosure;
Fig. 5C is a cross-sectional view taken along the direction 2B-2B in Fig. 5 according to an exemplary embodiment of the present disclosure;
Fig. 5D is a cross-sectional view taken along the direction 2B-2B in Fig. 5 according to an exemplary embodiment of the present disclosure;
Fig. 6 is a parallel impedance curve diagram corresponding to the bulk acoustic resonator in Fig. 5A;
Fig. 7 is a top view of a bulk acoustic resonator according to an exemplary embodiment of the present disclosure;
Fig. 7A is a cross-sectional view taken along the direction 3B-3B in Fig. 7 according to an exemplary embodiment of the present disclosure;
Fig. 7B is a cross-sectional view taken along the direction 3B-3B in Fig. 7 according to an exemplary embodiment of the present disclosure;
Fig. 7C is a cross-sectional view taken along the direction 3B-3B in Fig. 7 according to an exemplary embodiment of the present disclosure;
Fig. 7D is a cross-sectional view taken along the direction 3B-3B in Fig. 7 according to an exemplary embodiment of the present disclosure;
Fig. 8 is a parallel impedance curve diagram corresponding to the bulk acoustic resonator in Fig. 7A;
Fig. 9 is a top view of a bulk acoustic resonator according to an exemplary embodiment of the present disclosure; and
Fig. 10 is a cross-sectional view taken along the direction 3B-3B in Fig. 9.

### Detailed Description of the Embodiments

The technical solutions of the present disclosure will be further described below in detail through embodiments and in conjunction with the drawings. In the specification, the same or similar reference signs indicate the same or similar components. The following description of the embodiments of the present disclosure with reference to the drawings is intended to explain the general inventive concept of the present disclosure, and should not be construed as a limitation to the present disclosure.

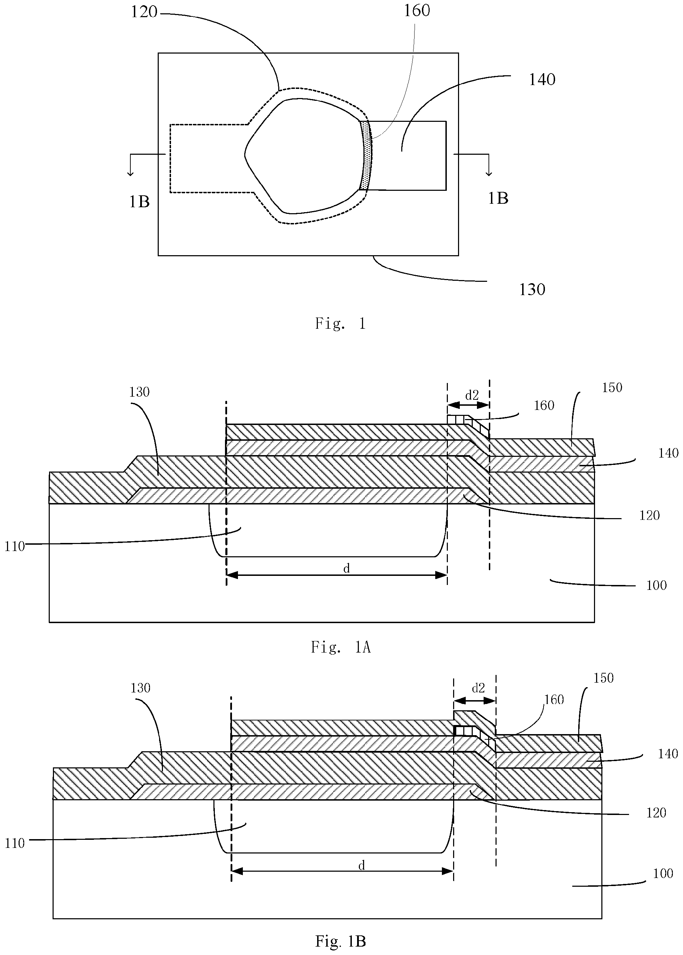

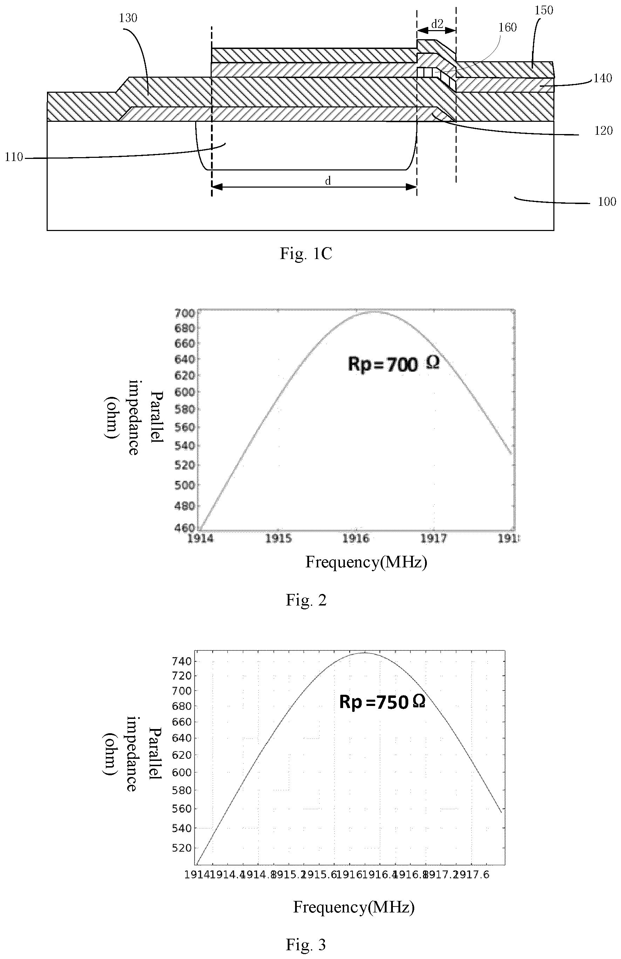

Fig. 1 is a top view of a bulk acoustic resonance structure of an exemplary embodiment. As shown in Fig. 1, the bulk acoustic resonator includes a bottom electrode 120, a piezoelectric layer 130, a top electrode 140 and an extension structure 160.

Fig. 1A is a cross-sectional view of a bulk acoustic resonator according to an exemplary embodiment of the present disclosure taken along the 1B-1B in the top view of Fig. 1. As shown in Fig. 1A, the bulk acoustic resonator includes a substrate 100 and an acoustic mirror 110, the acoustic mirror is located on the upper surface of the substrate or is embedded into the substrate, the acoustic mirror comprises a cavity embedded into the substrate in Fig. 1A, but any other acoustic mirror structures, such as a Bragg reflector, are also applicable.

The bulk acoustic resonator further includes a bottom electrode 120, a piezoelectric layer 130, a top electrode 140, a passivation layer 150 and an extension structure 160. The bottom electrode 120 is arranged above the acoustic mirror 110 and covers the acoustic mirror.

The edge of the bottom electrode 120 can be etched into an inclined plane, and the inclined plane is located at the outside of the acoustic reflector. In addition, the edge of the bottom electrode 120 can be stepped, vertical, or other similar structures.

As shown in Fig. 1A, in an optional embodiment, the extension structure 160 starts from an effective region on one side of a connection edge and can selectively extend to the bottom end of a bevel edge of the bottom electrode 120. It should be pointed out that, as long as the extension structure 160 includes a main extension part located between the edge of the effective region (the region shown by d in Fig. 1A) and the edge of the bottom electrode (i.e., in the region of d2) on the projection along the thickness direction of the resonator, and the main extension part does not need to start from the edge of the effective region or terminate at a position corresponding to the edge of the bottom electrode.

The region shown by d in Fig. 1A is the effective region of the resonator, and has first acoustic impedance, and the region shown by d2 includes the extension structure 160, the passivation layer 150, the top electrode 140, the piezoelectric layer 130, the bottom electrode 120 and the high-resistance silicon substrate 100, and has second acoustic impedance. Since the acoustic impedance of the region d is smaller than the acoustic impedance of the region d2, the acoustic waves are reflected at the boundary. Therefore, at the boundary, a part of acoustic energy is reflected into the effective region and can be converted into a piston acoustic wave mode perpendicular to the surface of the piezoelectric layer again, so that the parallel impedance Rₚ can be effectively improved. The size d2 of the extension structure OB' can be selected to adjust the reflection coefficient of the acoustic waves reflected from the edge of the lateral mode and the conversion efficiency of converting the lateral acoustic wave mode into the piston mode. In an optional embodiment, considering the photoetching alignment accuracy, d2 is greater than 1 µm.

Fig. 2 shows a parallel impedance curve diagram of a bulk acoustic resonator without an extension structure. As shown in Fig. 2, the parallel impedance R_{P} is only 700Ω.

Fig. 3 is a parallel impedance curve of a bulk acoustic resonator provided with an extension structure according to an exemplary embodiment of the present disclosure. As shown in Fig. 3, the parallel impedance R_{P} of the resonator can reach 750Ω after the extension structure is added. It can be seen that the providing of the extension structure 160 increases the parallel impedance R_{P} of the resonator by 50Ω (an increase of about 7%) compared with Fig. 2.

The structure of the bulk acoustic resonator shown in Fig. 1B is similar to the structure in the embodiment shown in Fig. 1A, and Fig. 1A and Fig. 1B both are cross-sectional views taken along 1B-1B in the top view of Fig. 1. The difference is that the extension structure 160 is located between the top electrode 140 and the passivation layer 150 in Fig. 1B.

The structure of the bulk acoustic resonator shown in Fig. 1C is similar to the structure in the embodiment shown in Fig. 1A, and Fig. 1A and Fig. 1C both are cross-sectional views taken along 1B-1B in the top view of Fig. 1. The difference is that the extension structure 160 is located between the piezoelectric layer 130 and the top electrode 140 in Fig. 1C.

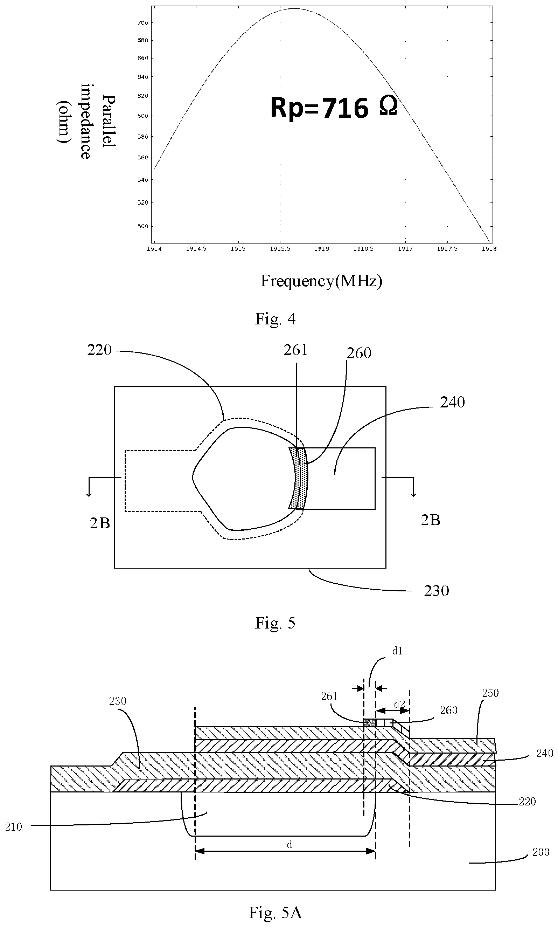

Considering the process compatibility and the degree of increase in the parallel impedance Rₚ, the extension structure 160 can also extend inward into the effective region, but it cannot be provided only at the inner side of the effective region. Fig. 4 is a parallel impedance curve diagram of a bulk acoustic resonator only provided with an extension structure at the inner side of the effective region. As shown in Fig. 4, the parallel impedance Rₚ is only 716Ω, which indicates that the arrangement of the extension structure only at the inner side of the effective region does not play a good role of improving the parallel impedance.

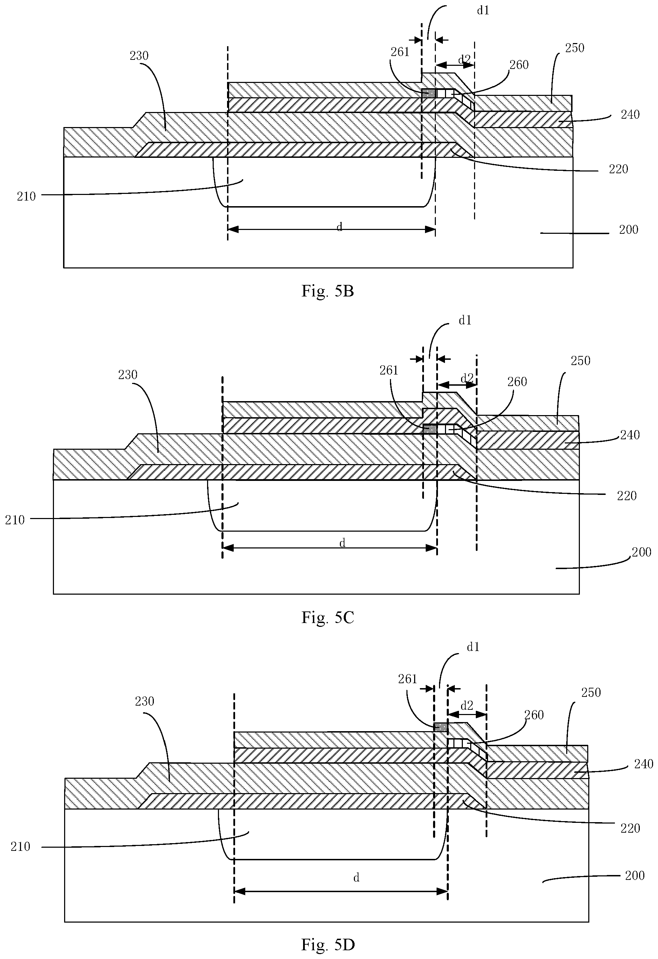

Fig. 5 is a top view of a bulk acoustic wave resonance structure according to an exemplary embodiment of the present disclosure. As shown in Fig. 5, the bulk acoustic resonator includes a bottom electrode 220, a piezoelectric layer 230, a top electrode 240, a protrusion structure 261 and an extension structure 260.

The embodiment shown in Fig. 5A is a cross-sectional view of the bulk acoustic resonator taken along 2B-2B in the top view of Fig. 5. The bulk acoustic resonator includes a substrate 200 and an acoustic mirror 210, the acoustic mirror is located on the upper surface of the substrate or is embedded into the substrate, the acoustic mirror comprises a cavity embedded into the substrate in Fig. 5A, but any other acoustic mirror structures, such as a Bragg reflector, are also applicable.

As shown in Fig. 5A, the bulk acoustic resonator further includes a bottom electrode 220, a piezoelectric layer 230, a top electrode 240, a passivation layer 250, a protrusion structure 261 and an extension structure 260. The bottom electrode 220 is arranged above the acoustic mirror 210 and covers the acoustic mirror. The edge of the bottom electrode 220 can be etched into an inclined plane, and the inclined plane is located at the outside of the acoustic reflector. In addition, the edge of the bottom electrode can also be stepped, vertical, or other similar structures.

In an optional embodiment, the height of the extension structure 260 is greater than or equal to the height of the protrusion structure 261.

In an optional embodiment, the acoustic impedance of the material of the extension structure 260 is greater than or equal to the acoustic impedance of the material of the protrusion structure 261. In addition, the extension structure 260 can selectively extend to the bottom edge of the bevel edge of the bottom electrode 220.

The region shown by d in Fig. 5A is the effective region of the resonator, and the region shown by d1 is a part of the effective region of the resonator, including the protrusion structure 261, the passivation layer 250, the top electrode 240, the piezoelectric layer 230, the bottom electrode 220 and the cavity 210, and having first acoustic impedance. The region shown by d2 in Fig. 5A includes the extension structure 260, the passivation layer 250, the top electrode 240, the piezoelectric layer 230, the bottom electrode 220 and the high-resistance silicon substrate 200, and has second acoustic impedance. Since the acoustic impedance of the region d1 is smaller than the acoustic impedance of the region d2, the acoustic waves are reflected at the boundary. Therefore, at the boundary, a part of acoustic energy is reflected into the effective region and can be converted into the piston acoustic wave mode perpendicular to the surface of the piezoelectric layer again, so that the parallel impedance Rₚ can be effectively improved. The size d1 of the protrusion structure 261 and the size d2 of the extension structure 260 can be selected to adjust the reflection coefficient of the acoustic waves reflected from the edge of the lateral mode and the conversion efficiency of converting the lateral acoustic wave mode into the piston mode. Considering the photoetching alignment accuracy, in one embodiment, d2 is greater than 1 µm.

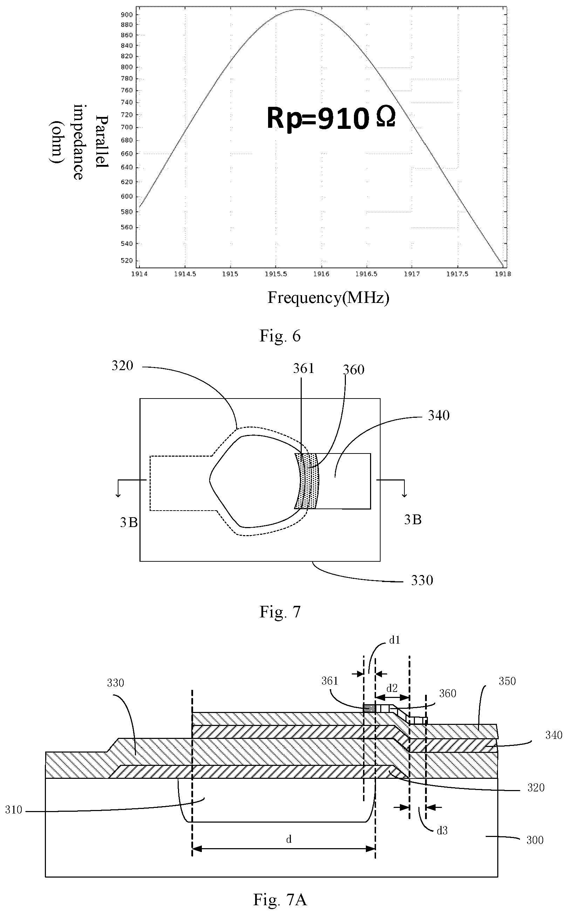

Fig. 6 is a parallel impedance curve diagram corresponding to the bulk acoustic resonator in Fig. 5A. As shown in Fig. 6, the corresponding parallel impedance R_{P} can be increased to 910Ω (an increase of about 30%).

The structure of the bulk acoustic resonator shown in Fig. 5B is similar to the structure in the embodiment shown in Fig. 5A, and Fig. 5A and Fig. 5B both are cross-sectional views taken along 2B-2B in the top view of Fig. 5. The difference is that the protrusion structure 261 and the extension structure 260 are located between the top electrode 240 and the passivation layer 250 in Fig. 5B.

The structure of the bulk acoustic resonator shown in Fig. 5C is similar to the structure in the embodiment shown in Fig. 5A, and Fig. 5A and Fig. 5C both are cross-sectional views taken along 2B-2B in the top view of Fig. 5. The difference is that the protrusion structure 261 and the extension structure 260 are located between the piezoelectric layer 230 and the top electrode 240 in Fig. 5C.

The structure of the bulk acoustic resonator shown in Fig. 5D is similar to the structure in the embodiment shown in Fig. 5A, and Fig. 5A and Fig. 5D both are cross-sectional views taken along 2B-2B in the top view of Fig. 5. The difference is that the protrusion structure 261 is located above the passivation layer 250, and the extension structure 260 is located below the passivation layer 250. Any other random combinations of the protrusion structure 261 and the extension structure 260 are included in the protection scope of the present disclosure, as long as the impedance of the region shown by d2 is higher than the impedance of the region shown by d1.

Considering the influence of the photoetching alignment accuracy and the etching accuracy, it is difficult to ensure the dimensional stability of d2 in the actual process. In order to stably improve the parallel impedance Rₚ, it is necessary to continue to extend the extension structure 260 to the outer side of the edge of the bottom electrode 220 pattern.

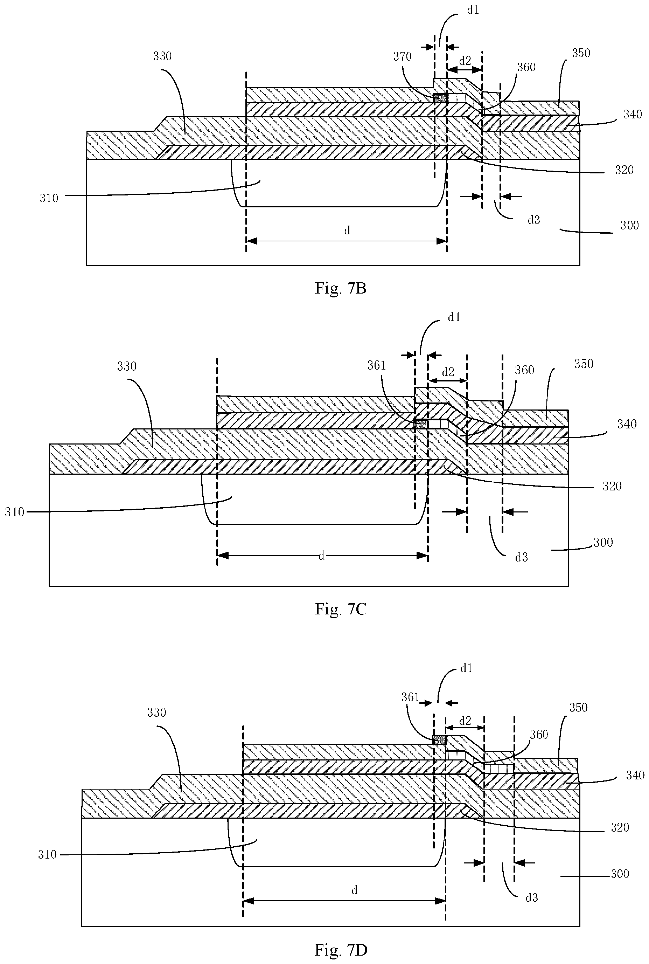

The embodiment shown in Fig. 7 is a top view of a bulk acoustic wave resonance structure. The bulk acoustic resonator includes a bottom electrode 320, a piezoelectric layer 330, a top electrode 340, a protrusion structure 361, and an extension structure 360.

Fig. 7A is a cross-sectional view of the bulk acoustic resonator taken along 3B-3B in the top view of Fig. 7A. The bulk acoustic resonator includes a substrate and an acoustic mirror 310, the acoustic mirror is located on the upper surface of the substrate or is embedded into the substrate, the acoustic mirror comprises a cavity embedded into the substrate in Fig. 7A, but any other acoustic mirror structures, such as a Bragg reflector, are also applicable.

The bulk acoustic resonator further includes a bottom electrode 320, a piezoelectric layer 330, a top electrode 340, a passivation layer 350, a protrusion structure 361 and an extension structure 360. The bottom electrode 320 is arranged above the acoustic mirror and covers the acoustic mirror. The edge of the bottom electrode 320 can be etched into an inclined plane, and the inclined plane is located at the outside of the acoustic reflector. In addition, the edge of the bottom electrode 320 can also be stepped, vertical, or other similar structures. The height of the extension structure 360 should be greater than or equal to the height of the protrusion structure 361. The acoustic impedance of the material of the extension structure 360 should be greater than or equal to the acoustic impedance of the material of the protrusion structure 361, and the extension structure 360 extends to the outer side of the bottom electrode 320 pattern.

The region shown by d in Fig. 7A is the effective region of the resonator, and the region shown by d1 in Fig. 7A is a part of the effective region of the resonator, including the protrusion structure 361, the passivation layer 350, the top electrode 340, the piezoelectric layer 330, the bottom electrode 320 and the cavity, and having first acoustic impedance. The region shown by d2 includes the extension structure 360, the passivation layer 350, the top electrode 340, the piezoelectric layer 330, the bottom electrode 320 and the high-resistance silicon substrate, and has second acoustic impedance. The region shown by d3 includes the extension structure 360, the passivation layer 350, the top electrode 340, the piezoelectric layer 330 and the high-resistance silicon substrate 300. Since the acoustic impedance of the region d1 is smaller than the acoustic impedance of the region d2, the transmission of the acoustic waves at the boundary is not continuous. Therefore, at the boundary, a part of acoustic energy is coupled and reflected into an effective excitation region and is converted into the piston acoustic wave mode perpendicular to the surface of the piezoelectric layer again, so that the parallel impedance Rₚ can be effectively improved. The size d3 of the extension structure 360 can be selected to adjust the reflection coefficient of the acoustic waves reflected from the edge of the lateral mode and the conversion efficiency of converting the lateral acoustic wave mode into the piston mode. Considering the photoetching alignment accuracy, in one embodiment, d3 is greater than 2 µm.

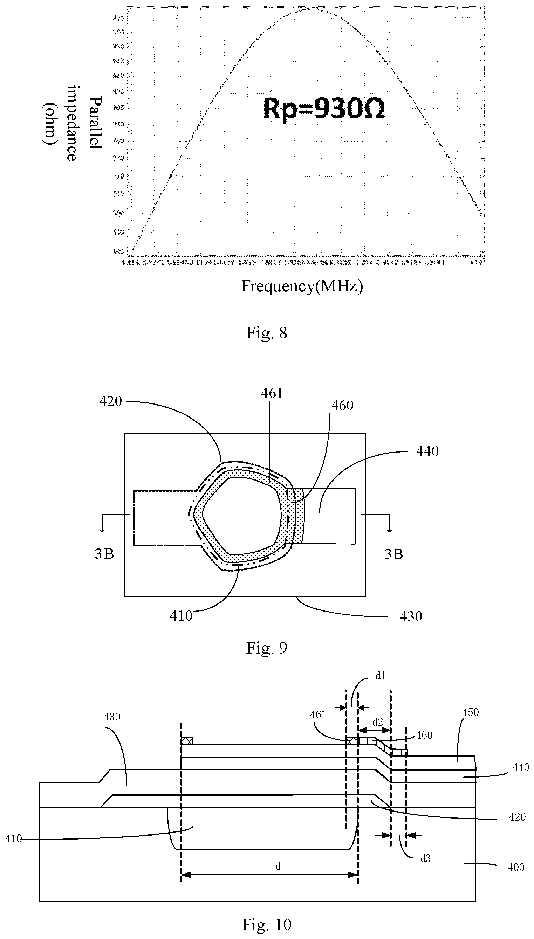

Fig. 8 is a parallel impedance curve diagram corresponding to the bulk acoustic resonator in Fig. 7A. As shown in Fig. 8, the parallel impedance Rₚ of the bulk acoustic resonator in Fig. 7A can be increased to 930Ω (an increase of about 33%).

The structure of the bulk acoustic resonator shown in Fig. 7B is similar to the structure in the embodiment shown in Fig. 7A, and Fig. 7A and Fig. 7B both are cross-sectional views taken along 3B-3B in the top view of Fig. 7. The difference is that the protrusion structure 361 and the extension structure 360 are located between the top electrode 340 and the passivation layer 350 in Fig. 7B.

The structure of the bulk acoustic resonator shown in Fig. 7C is similar to the structure in the embodiment shown in Fig. 7A, and Fig. 7A and Fig. 7C both are cross-sectional views taken along 3B-3B in the top view of Fig. 7. The difference is that the protrusion structure 361 and the extension structure 360 are located on the piezoelectric layer 330 in Fig. 7C.

The structure of the bulk acoustic resonator shown in Fig. 7D is similar to the structure in the embodiment shown in Fig. 7A, and Fig. 7A and Fig. 7D both are cross-sectional views taken along 3B-3B in the top view of Fig. 7. The difference is that the protrusion structure 361 is located above the passivation layer 350, and the extension structure 360 is located below the passivation layer 350 in Fig. 7D. Any other random combinations of the protrusion structure 361 and the extension structure 360 are included in the protection scope of the present disclosure, as long as the impedance of the region shown by d2 is higher than the impedance of the region shown by d1.

Fig. 9 is a top view of a bulk acoustic resonator according to an exemplary embodiment of the present disclosure; and Fig. 10 is a cross-sectional view taken along the direction 3B-3B in Fig. 9. As shown in Figs. 9-10, the resonator includes: a substrate 400, an acoustic mirror 410, a bottom electrode 420, a piezoelectric layer 430, a top electrode 440, a passivation layer 450, and an extension structure 460 (having a main extension part in the region d2 and an auxiliary extension part in the region d3). The resonator further includes an annular protrusion 461, the annular protrusion 461 is arranged in a ring shape at the inner side of the effective region, and the protrusion structure (the region d1 in Fig. 10) is a component of the annular protrusion.

Based on the above description, the present disclosure proposes a bulk acoustic resonator, including:
a substrate, for example 100;
an acoustic mirror, for example 110;
a bottom electrode, for example 120, arranged above the substrate;
a top electrode, for example 140; and
a piezoelectric layer, for example 130, arranged above the bottom electrode and between the bottom electrode and the top electrode,
wherein:
   the overlapping region of the acoustic mirror, the bottom electrode, the piezoelectric layer and the top electrode in the thickness direction of the resonator constitutes an effective region d of the resonator; and
   the resonator is provided with an extension structure, for example 160, (see Fig. 1A, Fig. 1B and Fig. 1C) at the position of an electrode connection part of the top electrode, and the extension structure includes a main extension part located between the edge of the effective region and the edge of the bottom electrode on the projection along the thickness direction of the resonator.

As shown in Figs. 1A-1C, Figs. 5A-5D, and Figs. 7A-7D, in an optional embodiment, the main extension part is within the range of d2.

As shown in Fig. 7A and Fig. 7D, the other end (the right side in the figure) of the main extension part is further connected with the auxiliary extension part (within the region of d3).

As shown in Figs. 5A-5D and Figs. 7A-7D, one end (the left side in the figure) of the main extension part can be further provided with a protrusion structure. In addition, as shown in Fig. 5D and Fig. 7D, the protrusion structure and the main extension structure may not be on the same layer or are in a mutually connected state.

As shown in Figs. 1A-1C, Figs. 5A-5D, and Figs. 7A-7D, the extension structure can be in different interlayer positions or in different layers.

In the present disclosure, the extension structure is arranged on the outer side of the effective region on the side where the top electrode and the bottom electrode of the resonator are connected. The extension structure can effectively improve the impedance mismatch between the effective resonance region and the outer side region at the top electrode connection edge, and enhance the reflection of the lateral parasitic mode, thereby reducing the influence of the lateral parasitic mode on the performance of the resonator, and effectively improving the value of the parallel impedance Rₚ.

The materials of the components of the bulk acoustic resonator according to the present disclosure will be exemplarily and simply illustrated below.

In the present disclosure, the material of the electrodes can be formed by gold (Au), tungsten (W), molybdenum (Mo), platinum (Pt), ruthenium (Ru), iridium (Ir), titanium tungsten (TiW), aluminum (Al), titanium (Ti), osmium (Os), magnesium (Mg), germanium (Ge), copper (Cu), chromium (Cr), arsenic doped gold and other similar metals.

In the present disclosure, the material of the piezoelectric layer can be aluminum nitride (AlN), doped aluminum nitride (doped ALN), zinc oxide (ZnO), lead zirconate titanate (PZT), lithium niobate (LiNbO₃), quartz (Quartz), potassium niobate (KNbO₃) or lithium tantalate (LiTaO₃) and other materials, wherein the doped ALN contains at least one rare earth element, such as scandium (Sc), yttrium (Y), magnesium (Mg), titanium (Ti), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.

In the present disclosure, the material of the substrate includes, but is not limited to: single crystal silicon (Si), gallium arsenide (GaAs), sapphire, quartz, etc.

In the present disclosure, the passivation layer is made of a dielectric material, and the dielectric material can be selected from, but is not limited to: silicon dioxide (SiO₂), silicon nitride (Si₃N₄), silicon carbide (SiC), aluminum nitride (AlN), aluminium oxide (Al₂O₃) and so on.

The embodiments of the present disclosure further relate to a filter, including the above-mentioned bulk acoustic resonator.

The embodiments of the present disclosure further relate to an electronic equipment, including the above-mentioned filter or resonator. It should be pointed out that the electronic equipment here includes, but is not limited to, intermediate products such as radio frequency front ends, filter amplifier modules, and terminal products such as mobile phones, WIFI, and drones.

Although the embodiments of the present disclosure have been shown and described, for those of ordinary skill in the art, it can be understood that modifications can be made to these embodiments without departing from the principle and spirit of the present disclosure, and the scope of the present disclosure is defined by the appended claims and their equivalents.

## Claims

1. A bulk acoustic resonator, comprising:
a substrate;
an acoustic mirror;
a bottom electrode arranged above the substrate;
a top electrode; and
a piezoelectric layer arranged above the bottom electrode and between the bottom electrode and the top electrode,
wherein:
the overlapping region of the acoustic mirror, the bottom electrode, the piezoelectric layer and the top electrode in the thickness direction of the resonator constitutes an effective region of the resonator; and
the resonator is provided with an extension structure at the position of an electrode connection part of the top electrode, and the extension structure comprises a main extension part located between the edge of the effective region and the edge of the bottom electrode on the projection along the thickness direction of the resonator.

2. The resonator according to claim 1, wherein:
the main extension part extends from the edge of the effective region.

3. The resonator according to claim 1 or 2, wherein:
the end of the main extension part away from the effective region is flush with the end part of the bottom electrode in the thickness direction of the resonator.

4. The resonator according to claim 3, wherein:
the extension distance of the main extension part is not less than 1 micron.

5. The resonator according to claim 3, wherein:
the extension structure further comprises an auxiliary extension part arranged on the same layer as the main extension part, and the auxiliary extension part is connected to the other end of the main extension part and extends beyond the bottom electrode on the projection in the thickness direction of the resonator.

6. The resonator according to claim 5, wherein:
the extension length of the auxiliary extension part is not less than 2 microns.

7. The resonator according to any one of claims 1-6, wherein:
the resonator further comprises a passivation layer arranged above the top electrode; and
the extension structure is arranged on the passivation layer.

8. The resonator according to any one of claims 1-6, wherein:
the resonator further comprises a passivation layer arranged above the top electrode; and
the extension structure is arranged between the passivation layer and the top electrode.

9. The resonator according to any one of claims 1-6, wherein:
the extension structure is arranged between the top electrode and the piezoelectric layer.

10. The resonator according to any one of claims 1-9, wherein:
one end of the main extension part extends from the edge of the effective region; and
the resonator further comprises a protrusion structure extending from the edge of the effective region toward the effective region.

11. The resonator according to claim 10, wherein:
the protrusion structure is in the same layer as the main extension part, and is connected to the one end of the main extension part.

12. The resonator according to claim 10, wherein:
the protrusion structure and the main extension part are arranged in different layers.

13. The resonator according to claim 10, wherein:
the acoustic impedance of the material of the protrusion structure is not greater than the acoustic impedance of the material of the extension structure.

14. The resonator according to claim 10, wherein:
the thickness of the main extension part is not less than the thickness of the protrusion structure.

15. The resonator according to claim 10, wherein:
the resonator further comprises an annular protrusion, the annular protrusion is arranged in a ring shape at the inner side of the effective region, and the protrusion structure is a component of the annular protrusion.

16. The resonator according to any one of claims 1-9, wherein:
the extension structure further comprises a second auxiliary extension part, and the second auxiliary extension part is connected to one end of the main extension part and extends into the effective region.

17. A filter, comprising the bulk acoustic resonator according to any one of claims 1-16.

18. Electronic equipment, comprising the filter according to claim 17 or the bulk acoustic resonator according to any one of claims 1-16.
